Europäisches Patentamt

European Patent Office

Office européen des brevets

(19)

(11) EP 0 778 469 B1

(12) **FASCICULE DE BREVET EUROPEEN**

(45) Date de publication et mention
de la délivrance du brevet:
**31.07.2002 Bulletin 2002/31**

(51) Int Cl.$^7$: **G01S 1/02**

(21) Numéro de dépôt: **96402566.2**

(22) Date de dépôt: **28.11.1996**

(54) **Procédé et dipositif pour le test d'instruments de radionavigation utilisant des appareils de mesure et de génération de signaux standards**

Verfahren und Vorrichtung zum Prüfen von Funknavigationsgeräten mit Messgeräten und Generatoren für Normsignale

Method and device for testing radio navigation instruments with devices for measuring and generating standard signals

(84) Etats contractants désignés:
**DE ES GB IT**

(30) Priorité: **08.12.1995 FR 9514744**

(43) Date de publication de la demande:
**11.06.1997 Bulletin 1997/24**

(73) Titulaire: **AEROSPATIALE Société Nationale Industrielle**
**75781 Paris Cédex 16 (FR)**

(72) Inventeur: **Simonnet, Jean-Paul**
**91700 Sainte Geneviève des Bois (FR)**

(74) Mandataire: **de Saint-Palais, Arnaud Marie et al**
**CABINET MOUTARD**
**35 Rue de la Paroisse**
**BP 513**
**78005 Versailles Cedex (FR)**

(56) Documents cités:
**EP-A- 0 052 671**      **WO-A-93/08483**
**US-A- 4 641 254**

• **PROCEEDINGS OF SOUTHEASTCON, WILLIAMSBURG, APRIL 7 - 10, 1991, vol. 1, 1 Janvier 1991, INSTITUTE OF ELECTRICAL AND ELECTRONICS ENGINEERS, pages 401-404, XP000286882 JUDGE D M: "TRENDS IN AUTOMATIC TESTING OF ELECTRONIC DEVICES"**
• **FIRMENSCHRIFT ROHDE UND SCHWARZ, no. 214311, 1 Janvier 1971, pages 1-8, XP002010359 "TEST ASSEMBLY FOR AIR NAVIGATION AND COMMUNICATION RECEIVERS"**
• **NAVY TECHNICAL DISCLOSURE BULLETIN, vol. 8, no. 3, 1 Mars 1983, pages 23-26, XP002010360 ORME D D ET AL: "IFF SIMULATOR"**

## Description

La présente invention concerne un procédé et un dispositif pour le test d'instruments de radio-navigation.

Elle s'applique notamment, mais non exclusivement, aux systèmes de test automatique utilisés pour tester les instruments de radio-navigation utilisés à bord des aérodynes. De tels systèmes comprennent généralement un calculateur conçu pour pouvoir exécuter automatiquement des séquences de test au cours desquels des appareils de mesure et de génération de signaux sont pilotés par le calculateur en vue d'appliquer des stimuli à l'équipement à tester et d'en mesurer les effets.

Lorsqu'il s'agit de tester des instruments de radio-navigation, il est nécessaire de pouvoir engendrer et analyser des formes de signaux complexes qui sont traitées et/ou engendrées par ces instruments.

Par ailleurs, il existe de nombreux systèmes de radio-navigation différents tels que :

- VOR (Visual Omnidirectional Range),
- ILS (Instrument Landing System),
- TACAN (Tactical Air Navigation),
- IFF (Identification Friend and Foe),
- DME (Distance Measurement Equipement),
- GPS (Global Positioning System),
- systèmes radar,
- radio-altimètres.

En particulier, le document "FIRMENSCHRIFT ROHDE UND SCHWARZ" n° 214 311, du 1er janvier 1971, décrit un appareil spécialement conçu pour tester la fonction VOR-ILS.

Tous ces systèmes utilisent des formes de signaux complexes qui leur sont propres, lesquelles sont définies par des normes précises et distinctes.

Pour tester les instruments de radio-navigation, on a donc développé autant d'appareils de génération et de mesure de signaux que de types de signaux de radio-navigation. Il s'avère que cette solution présente un coût et un encombrement très élevés. Certains fabricants ont donc mis au point des appareils capables d'engendrer plusieurs types de signaux, en partant de la constatation suivant laquelle les systèmes de radio-navigation conjuguent des signaux dans le domaine des basses fréquences avec des signaux dans le domaine des hautes fréquences. Or ces deux domaines peuvent être dissociés car il n'existe aucune interaction entre eux. En fait, le signal utile est un signal basse fréquence simple, comme par exemple un train d'impulsions tel que ceux utilisés dans les systèmes DME et IFF, ou bien un signal basse fréquence composite comme la modulation de fréquence utilisée dans le système VOR. Toutes les opérations effectuées sur les signaux basse fréquence restent néanmoins simples et sont limitées à des combinaisons de modulations et d'additions.

Cependant, de tels appareils restent limités à un ou deux types de signaux de radio-navigation.

Dans ses conclusions, le document "Proceeding of Southeastcom, Williamsburg", April 7-10, 1991, fait apparaître la complexité des systèmes de test automatique dans les domaines militaires et avioniques.

La présente invention a pour but de supprimer ces inconvénients. A cet effet, elle propose un procédé pour le test d'instruments de radio-navigation utilisant un système de test automatique pilotant des appareils de mesure et de génération de signaux électriques, lesdits instruments utilisant des signaux basse fréquence de formes complexes qui modulent une porteuse haute fréquence.

Ce procédé est caractérisé en ce qu'il comprend:

- l'utilisation de plusieurs appareils de génération de signaux arbitraires programmables points par points qui sont chacun aptes à engendrer un signal primaire basse fréquence présentant des formes d'onde de signaux utilisés dans le domaine de la radionavigation et qui est destiné à moduler une porteuse correspondante délivrée par un générateur haute fréquence à large bande,

- la combinaison de signaux primaires délivrés par lesdits appareils pour obtenir des signaux composites basse fréquence correspondants à des signaux de radionavigation différents,

- pour chacun des signaux de radionavigation, la sélection d'une porteuse haute fréquence et l'émission de cette porteuse haute fréquence modulée par le signal composite basse fréquence de manière à obtenir un signal modulé composite,

- l'application du signal modulé composite à l'instrument à tester,

- l'analyse des signaux délivrés par l'équipement à tester par des appareils de mesure et d'analyse,

lesdits générateurs arbitraires et le générateur haute fréquence étant pilotés par un calculateur associé à des moyens de commutation de manière à obtenir sélectivement les susdits signaux composites, à sélectionner la porteuse appropriée à ces signaux composites de manière à obtenir sélectivement lesdits signaux modulés composites, à appliquer ces signaux modulés composites à l'instrument à tester et à effectuer les analyses correspondant à ces signaux modulés composites et à pouvoir exécuter des séquences de test définies au moyen d'un langage de programmation de haut niveau.

En se basant sur un concept d'instrumentation virtuelle, cette solution permet grâce à la réalisation d'un seul dispositif de conception simple, d'engendrer tous les signaux que l'on cherche à synthétiser.
Par rapport à la solution qui consiste à réaliser autant d'appareils de génération de signaux que de types de signaux de radio-navigation à engendrer, on évite ainsi de dupliquer inutilement les fonctions de base de synthèse de signaux, les appareils de génération de signaux de base restant disponibles pour d'autres utilisations.
Cette solution permet également d'économiser une interface de commande par type de signal à engendrer.

L'invention concerne également un dispositif pour le test d'instruments de radio-navigation, ce dispositif étant connecté à des appareils de génération et de mesure de signaux, et comprenant des moyens pour engendrer un signal composite basse fréquence en combinant des signaux primaires basse fréquence provenant desdits moyens de génération, des moyens pour moduler une porteuse haute fréquence provenant desdits appareils de génération et de mesure de signaux, par le signal composite basse fréquence.

Un mode de réalisation du procédé et du dispositif selon l'invention sera décrit ci-après, à titre d'exemple non limitatif, avec référence aux dessins annexés dans lesquels :

La figure 1 représente schématiquement un système de test automatique comprenant un dispositif pour la génération et la mesure de signaux de radio-navigation selon l'invention ;
La figure 4 montre en détail une partie du dispositif selon l'invention.

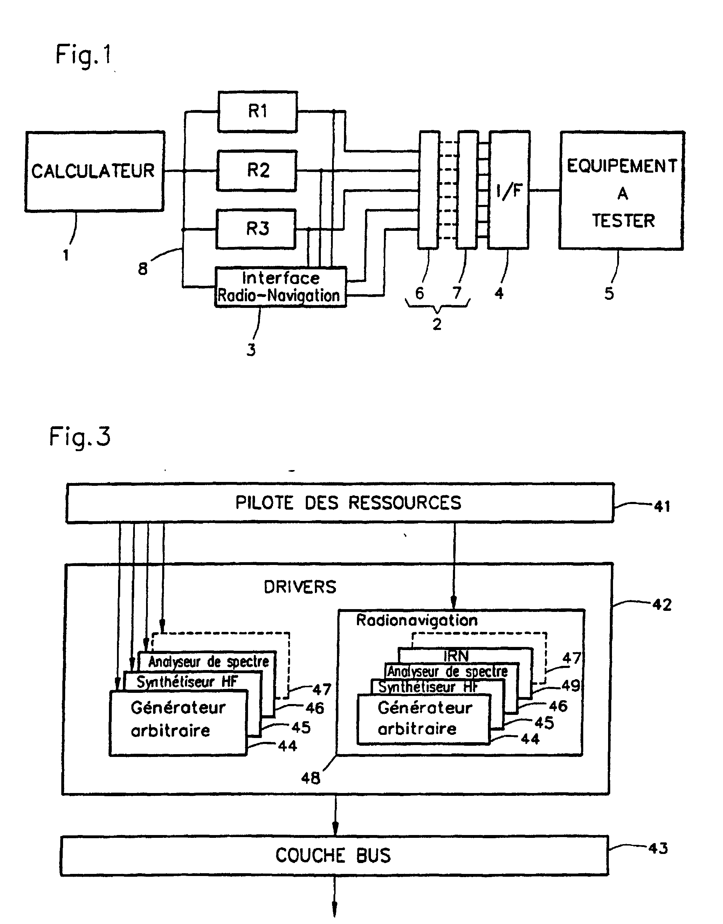

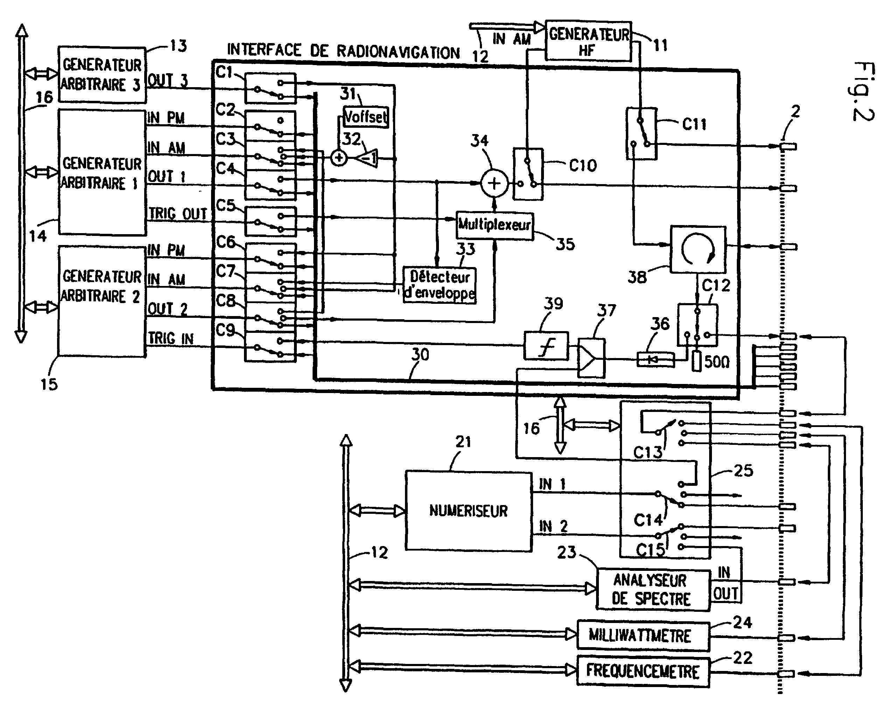

La figure 1 montre un système de test automatique comprenant un calculateur 1 connecté par un bus 8 à une pluralité de ressources de test R1,R2,R3, tels que des appareils de mesure et de génération de signaux. Ce calculateur 1 est apte à exécuter automatiquement une séquence de test automatique et à piloter les différentes ressources de test R1,R2,R3 raccordées au bus 8. Les entrées et sorties de signaux de ces ressources de test sont appliquées à l'équipement à tester 5 par l'intermédiaire d'un connecteur 2 comprenant deux éléments de connexion 6,7 mâle et femelle, et d'une interface de test 4.

En outre, pour pouvoir engendrer et analyser des signaux de forme complexe tels que des signaux de radio-navigation comme ceux qui sont utilisés dans l'aviation, ce système de test comprend un dispositif d'interface de radio-navigation 3 selon l'invention connecté au bus 8 de manière à pouvoir être piloté par le calculateur 1, et raccordé aux entrées et sorties des ressources de test R1,R2,R3, et au connecteur 2.

Ainsi, sur la figure 2, le dispositif d'interface de radio-navigation 3 est connecté à un ensemble de générateurs de signaux, tels qu'un générateur de signaux haute fréquence 11, et trois générateurs arbitraires 13,14,15.

Le générateur HF 11 doit être large bande (supérieure à 30 MHz) sur son entrée de modulation d'amplitude, de manière à pouvoir fournir toutes les porteuses utilisées dans le domaine de la radio-navigation, et à moduler celles-ci en amplitude.

Les générateurs arbitraires se programment point par point et permettent ainsi d'obtenir à peu près toutes les formes d'onde de signal. Pour cela, ils peuvent être programmés en introduisant une séquence de points d'une certaine longueur et une valeur de pas d'échantillonnage (par exemple 40 ns). Cette séquence de points peut être répétée indéfiniment ou pendant un certain nombre de cycles en fonction d'un mode de fonctionnement à sélectionner.

Pour pouvoir effectuer l'analyse des signaux délivrés par l'équipement à tester 5, le dispositif d'interface 3 est connecté à des appareils de mesure tels qu'un numériseur 21, un fréquencemètre 22, un milliwattmètre 24 et un analyseur de spectre 23. On utilise également un dispositif de commutation 25 permettant d'orienter ou combiner les différents signaux en provenance des ressources de test et de l'interface de test 4.

Ces appareils de mesure et de génération de signaux, ainsi que le dispositif d'interface de radio-navigation 3 sont commandés par le calculateur 1. A cet effet, ils sont connectés au calculateur 1 grâce à des bus de transmission de données numériques, tels que IEEE 12 pour le générateur HF 11 et les instruments de mesure 21 à 24, et VXI 16 pour les générateurs arbitraires 13 à 15 et le dispositif d'interface 3.

Le dispositif d'interface 3 comprend un ensemble de commutateurs C1 à C11 commandés par l'intermédiaire du bus VXI 16 et dont la position de repos permet de relier l'entrée du commutateur au connecteur 2 par l'intermédiaire d'un bus local 30.
Le commutateur C1 à deux positions est connecté en entrée à la sortie du générateur arbitraire 13. Par ailleurs, la sortie en position active de ce commutateur C1 est reliée d'une part aux entrées respectives du signal de modulation en phase et en amplitude du générateur arbitraire 15 respectivement par l'intermédiaire des commutateurs C6,C7, et d'autre part à l'entrée de modulation en amplitude du générateur arbitraire 14 par l'intermédiaire d'un inverseur 32 et du commutateur C3.

En position active, le commutateur C2 à deux positions permet de déconnecter l'entrée de modulation en phase du générateur arbitraire 14 du bus local 30.

En position active, le commutateur C3 à trois positions permet d'appliquer à l'entrée de modulation en amplitude du générateur arbitraire 14, soit le signal de sortie de l'inverseur 32 auquel est ajouté un offset en tension 31 dont la valeur est programmable, soit la sortie du générateur arbitraire 15 par l'intermédiaire du commutateur C8.

En position active, le commutateur C4 à deux positions permet de diriger la sortie du générateur arbitraire 14 vers l'entrée d'un additionneur 34 et d'un détecteur d'enveloppe 33, tandis que le commutateur C5 à deux positions permet d'appliquer la sortie de déclenchement du générateur arbitraire 14 à l'entrée de commande d'un multiplexeur analogique 35.

En position active, le commutateur C6 à deux positions relie l'entrée de modulation en phase du générateur arbitraire 15 au commutateur C1.

En position active, le commutateur C7 à trois positions permet également de relier la sortie du détecteur d'enveloppe 33 à l'entrée de modulation en amplitude du générateur arbitraire 15.

En position active, le commutateur C8 à trois positions permet également d'appliquer la sortie du générateur arbitraire 15 à l'entrée du multiplexeur analogique 35 dont la sortie est reliée à l'entrée de l'additionneur 34.

En position active, le commutateur C9 à deux positions permet d'appliquer à l'entrée de déclenchement du générateur arbitraire 15 le signal issu d'un détecteur de seuil 39.

Le commutateur C10 permet de connecter l'entrée de modulation en amplitude du générateur HF 11, en position active, à la sortie de l'additionneur 34, et en position de repos, directement au connecteur 2.

Le commutateur C11 permet de diriger la sortie du générateur HF 11 soit directement au connecteur 2 en position de repos, soit, en position active, vers l'entrée émission d'un circulateur 38 dont l'entrée/sortie émission/réception est connectée au connecteur 2 et la sortie réception à un commutateur C12.

Le commutateur C12 permet d'orienter le signal en entrée soit vers le connecteur 2, soit à la masse avec une impédance de 50 Ω permettant d'éviter la réflexion du signal vers la source, soit à un détecteur 36 qui permet de démoduler le signal HF, dont la sortie est appliquée à l'entrée d'un diviseur de puissance 37 permettant d'envoyer le signal dans deux lignes en respectant les impédances respectives de ces dernières.

Le diviseur de puissance 37 est relié en sortie au détecteur de seuil 39 et au dispositif de commutation 25 du système de test.

Le dispositif de commutation 25 comprend un ensemble de commutateurs C13,C14,C15 à plusieurs positions, commandés par le calculateur 1 grâce au bus VXI 16, le commutateur C13 permettant en position de repos d'isoler ses entrées du connecteur 2, tandis que entrées respectives des commutateurs C14 et C15 en position de repos sont reliées au connecteur 2.

Les bornes du commutateur C13 sont reliées à des broches respectives du connecteur 2, tandis que le commutateur C14 en position active applique sur la première entrée du numériseur 21, soit un signal interne de l'équipement à tester, soit la sortie du diviseur de puissance 37.

En position active, le commutateur C15 applique sur la seconde entrée du numériseur 21, soit un autre signal interne de l'équipement à tester, soit la sortie en fréquence intermédiaire FI de l'analyseur de spectre 23.

Par ailleurs, les entrées de l'analyseur de spectre 23, du fréquencemètre 22 et du milliwattmètre 24 sont reliées à des broches respectives du connecteur 2.

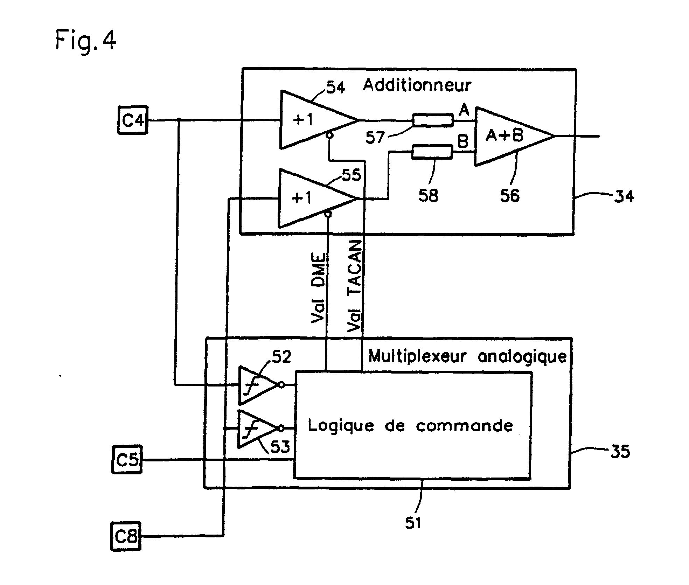

La figure 4 montre en détail l'additionneur 34 et le multiplexeur analogique 35. Sur cette figure, l'additionneur 34 comprend deux entrées reliées respectivement aux commutateurs C4 et C8, ces entrées étant appliquées à deux adaptateurs de signaux 54,55 dont les sorties sont connectées aux entrées de l'additionneur proprement dit 56 par l'intermédiaire de résistances 57,58 fixant son gain.

Le multiplexeur analogique 35 comprend une logique de commande 51 comportant trois entrées, à savoir, deux entrées reliées respectivement aux commutateurs C4 et C8 par l'intermédiaire de détecteurs à hystérésis inverseurs 52,53, et une entrées reliée au commutateur C5.

La logique de commande 51 comporte deux sorties reliées respectivement à l'entrée de commande des deux adaptateurs de signaux 54,55 de l'additionneur 34.

La logique de commande 51 peut être réalisée à partir de composants programmables, par exemple du type PAL ou EPLD. Elle est configurée par programmation via le bus VXI 16.

Le calculateur 1 est conçu de manière à pouvoir exécuter automatiquement des séquences de test définies au moyen d'un langage de programmation de haut niveau. Pour cela, il comprend un logiciel dont l'architecture est représentée figure 3. Ce logiciel comprend une première couche 41 de pilotage des ressources de test capable d'exécuter une séquence de test comprenant des instructions de haut niveau de commande des différents appareils de génération et de mesure de signaux ainsi que des organes de commutation permettant d'établir les connexions nécessaires à la configuration de la séquence de test, entre les appareils et les différents points de tests de l'équipement à tester, ramenés sur l'interface de test 4.

Ce logiciel comprend une couche dite "drivers" 42 regroupant tous les "drivers" 44 à 48 respectifs des appareils mis en oeuvre, chaque driver contenant la traduction en langage de commande de bas niveau spécifique de l'appareil, des instructions de haut niveau permettant de définir une séquence de test. Cette couche "drivers" 42 comprend en particulier le driver 48 du dispositif d'interface de radio-navigation 3, lequel comprend les "drivers" des appareils 11,13,14,15 et 21 à 25 utilisés par le dispositif 3.

Ce logiciel comprend également une couche bus 43 qui permet d'émettre les différentes commandes de bas niveau déterminées par la couche "drivers" 42 à partir des commandes de haut niveau, sur les différents bus IEEE 12 et VXI 16 en fonction de la localisation des appareils destinataires de ces commandes.

Ainsi, le "driver" 48 du dispositif d'interface de radio-navigation 3 est capable de traduire une commande de génération de signal de radio-navigation indiquant uniquement le type du signal et les différents paramètres définissant ce signal, en une série de commandes élémentaires définissant les paramètres de fonctionnement du dispositif 3 et de chaque appareil de génération de signaux 11,13,14,15, à mettre en oeuvre.

La description qui suit montre comment le dispositif d'interface 3 décrit ci-avant peut assurer la synthèse et permettre l'analyse de signaux de radio-navigation, tels que les signaux VOR, ILS, DME, TACAN et IFF.

SIGNAUX VOR

Dans le cas d'un signal VOR qui permet de déterminer l'angle entre le nord magnétique et l'axe passant par la position du récepteur du signal et la balise émettrice, il s'agit de synthétiser un signal basse fréquence émis en modulation d'amplitude dans la bande VHF entre 108 et 118 MHz, et ayant pour équation mathématique :

$$VOR(t) = K \cos(\omega t - \varphi)] + K \cos((332wt - m \sin(\omega t)) + 0,5K \cos(34\omega t))$$

avec :

    m l'indice de modulation nominale de 16,
    K l'amplitude de modulation à 30%,
    $\omega$ la pulsation à 30 Hz,
    $\varphi$ le déphasage entre le signal de référence et le signal d'azimut, à 30 Hz.

Le dernier terme correspond à la modulation à 1020 Hz du signal d'identification de la balise VOR. Le signal VOR(t) se caractérise en fait par une porteuse modulée par un signal à 9960 Hz modulé en phase et en amplitude par un signal à 30 Hz.

Pour synthétiser le signal VOR(t) en mode statique, on utilise le générateur arbitraire 14 pour générer le signal basse fréquence et le générateur HF 11 pour générer la porteuse dans la bande VHF modulée par le signal basse fréquence.

Si l'on souhaite générer un tel signal en l'absence du signal d'identification de la balise, il suffit de programmer le générateur arbitraire 14 pour obtenir la forme d'onde définie par la relation suivante :

$$K \cos(\omega t - \varphi)] + K \cos(332\omega t - m \sin(\omega t))$$

Pour cela, il faut échantillonner le signal à une fréquence correspondant par exemple à 10 échantillons par période du signal de base, soit 10 x 9960 Hz, avec un nombre d'échantillons égal à la fréquence d'échantillonnage divisée par 30 Hz, ce qui correspond à 3320 échantillons, chacun ayant une amplitude donnée par la relation précédente.
Cette forme d'onde peut avantageusement être préchargée dans la mémoire du générateur arbitraire 14.

En présence du signal d'identification de la balise, on utilise la même fréquence d'échantillonnage et le même nombre d'échantillons préchargés, il suffit simplement d'ajouter à la relation précédente le terme suivant pour calculer la valeur de chacun des échantillons :

$$0,5K \cos(34\omega t).$$

Il suffit ensuite de commander le générateur HF 11 pour engendrer une porteuse à la fréquence VHF voulue, ainsi que le dispositif d'interface de radio-navigation 3, grâce aux commutateurs C4 et C10, de manière à ce que le signal de sortie du générateur 14 module la porteuse générée par le générateur HF 11, le commutateur C11 permettant d'appliquer la sortie du générateur HF 11 vers le connecteur 2.

En mode dynamique, il s'agit de simuler le signal reçu par un avion en approche d'une balise VOR. Dans ce contexte, l'équipement de bord reçoit une porteuse modulée par un signal de 9960 Hz qui lui-même est modulé en amplitude et en phase par un signal à 30 Hz de phase variable entre le 30 Hz de la modulation de phase et le 30 Hz de la modulation d'amplitude. L'écart de phase entre ces deux signaux permet à l'équipement de bord d'en déduire sa direction par rapport au nord magnétique.

Pour synthétiser un tel signal modulant, on utilise les trois générateurs arbitraires 13 à 15, à savoir :

- le générateur 14 pour générer le signal à 9960 Hz modulé en phase par un signal de 30 Hz avec un indice de modulation de 16,

- le générateur 15 pour générer le signal à 30 Hz utilisé pour moduler en amplitude le signal issu du générateur 14, et

- le générateur 13 pour générer le signal de modulation en phase du signal issu du générateur 15.

Le dispositif 3 permet d'assurer le rebouclage des générateurs comme précisé ci-dessus, et de transmettre le signal résultant sur l'entrée de modulation d'amplitude du générateur HF 11 qui fournit, selon les paramètres de programmation, le signal HF modulé en amplitude au connecteur 2. A cet effet, les commutateurs C1 et C7 sont basculés pour appliquer la sortie du générateur 13 à l'entrée de modulation d'amplitude du générateur 15, les commutateurs C8 et C3 sont commandés de manière à appliquer la sortie du générateur 15 à l'entrée de modulation en amplitude du générateur 14, et les commutateurs C4 et C10 sont basculés pour envoyer la sortie du générateur 14 vers l'entrée de modulation en amplitude du générateur HF 11.

SIGNAUX ILS

Les signaux ILS sont utilisés lors de l'atterrissage d'un avion et comprennent en fait trois types de signaux pour assurer trois fonctions distinctes :

- une fonction LOCALIZER qui assure le guidage latéral par rapport à l'axe de piste,
- une fonction GLIDE qui donne une information de verticale par rapport à une pente déterminée, et
- une fonction MARKER qui indique sous forme auditive et visuelle la distance de l'avion en trois points par rapport à l'entrée de piste.

La fonction LOCALIZER utilise un signal composite basse fréquence, porteur de l'information d'alignement par rapport à l'axe de la piste, ce signal modulant en amplitude la porteuse HF.

Ce signal comprend deux composantes respectivement à 90 Hz et 150 Hz auxquelles peut être superposé un signal d'identification à 1020 Hz, et il est émis en VHF dans la bande comprise entre 108,1 et 111,9 MHz.

L'information d'alignement est donnée par la prédominance de l'une ou l'autre des composantes à 90 et 150 Hz.

L'équation de ce signal est la suivante :

$$LOC(t) = K_1 \cos(3\omega t + \varphi) + K_2 \cos(5\omega t) + K_3 \cos(34\omega t)$$

où :

$K_1$ et $K_2$ sont les amplitudes pour une modulation de 0 à 40% respectivement des composantes à 90 Hz et 150 Hz, $K_1 + K_2$ étant toujours égal à 40 %,

$K_3$ est l'amplitude pour une modulation à 15 % du signal à 1020 Hz, et

$\varphi$ est le déphasage entre les composantes à 90 Hz et 150 Hz.

Dans le cas de la fonction GLIDE, on utilise le même signal LOC(t), mais dans lequel $K_1$ et $K_2$ sont choisis de manière à obtenir un taux de modulation $K_1 + K_2$ de 80 %, ce signal étant émis dans la bande UHF comprise entre 328,6 et 335,4 MHz.

Pour synthétiser les signaux LOCALIZER et GLIDE en mode statique, il suffit de commander le générateur arbitraire 14 de manière à engendrer le signal composite basse fréquence et de l'appliquer à l'entrée de modulation en amplitude du générateur HF 11.

Pour obtenir le signal basse fréquence de manière à ce qu'il soit parfaitement récurrent et stable, la période du signal à générer doit être un sous-multiple premier des fréquences à 90 et 150 Hz, soit 30 Hz, si l'on souhaite générer un signal sans la composante d'identification à 1020 Hz. La fréquence d'échantillonnage sera donc par exemple de 10 x 150 Hz et le nombre d'échantillons à calculer nécessaire de 1500 Hz divisé par 30 Hz, soit 50, l'amplitude de chacun de ces échantillons étant calculée en appliquant l'équation LOC(t) sans la composante d'identification.

Pour synthétiser un signal basse fréquence incluant la composante d'identification à 1020 Hz, il faut utiliser une fréquence d'échantillonnage égale à 10 x 1020 Hz et un nombre d'échantillons de 10200 Hz divisé par 30 Hz, soit 340 échantillons, chacun ayant une amplitude calculée avec l'équation LOC(t) complète.

Les formes d'ondes ainsi définies peuvent être également préchargées dans la mémoire du générateur arbitraire 14.

Il suffit ensuite de commander le dispositif d'interface 3 pour faire basculer les commutateurs C4 et C10 de manière à appliquer la sortie du générateur 14 à l'entrée de modulation du générateur HF 11, et le commutateur C11 pour appliquer la sortie du générateur HF 11 au connecteur 2, le générateur HF étant commandé de manière à générer la porteuse modulée en amplitude correspondant à la fonction LOCALIZER ou GLIDE choisie.

En mode dynamique, il s'agit de simuler le signal reçu par un avion en approche de piste en phase d'atterrissage, et donc d'animer le signal basse fréquence. Pour cela on utilise les trois générateurs arbitraires 13 à 15, les formes d'ondes respectives étant préalablement chargées dans leurs mémoires, le générateur 14 servant à générer la composante à 150 Hz, le générateur 15, la composante à 90 Hz et le générateur 13, un signal modulant les composantes à 90 et 150 Hz.

Ainsi, les formes d'ondes préchargées dans les trois générateurs arbitraires 13 à 15 sont obtenues grâce aux fonctions suivantes :

- $\cos(3\omega t)$ pour le générateur 14,
- $\cos(5\omega t)$ pour le générateur 15, et
- U(t) avec $0 < U(t) < U1$, pour le générateur 13.

L'offset en tension 31 délivrant la tension U1 est programmé à 0,4 V pour le signal LOCALIZER, et à 0,8 V pour le signal GLIDE, de manière à obtenir des modulations $K_1 + K_2$ à respectivement 40 et 80 %.

La sortie du générateur 13 est appliquée grâce aux commutateurs C1, C3 et C7 à l'entrée de modulation en amplitude des générateurs 14 (source du 150 Hz) et 15 (source du 90 Hz), le signal appliqué au générateur 14 étant préalablement inversé grâce à l'inverseur 32 et décalé en amplitude par le décalage en tension 31, ceci afin d'obtenir une somme constante des coefficients $K_1$ et $K_2$ de modulation des composantes à 90 et 150 Hz.

Les signaux résultant des générateurs 14 et 15 sont appliqués aux entrées de l'additionneur 34 grâce aux commutateurs C4 et C8, et la sortie de l'additionneur 34 à l'entrée du générateur HF 11 grâce au commutateur C10.

Si l'on souhaite également introduire le signal d'identification à 1020 Hz, il suffit de programmer le générateur 13 de manière à obtenir un signal d'équation :

$$U(t) + 0{,}15 \ Veff \cos(34\omega t),$$

l'inverseur 32 permettant également de filtrer la composante à 1020 Hz de manière à ce que le signal d'identification soit fourni uniquement par le générateur 15.

La fonction MARKER est réalisée par trois balises au sol qui émettent des signaux codés en morse à des fréquences différentes selon la distance de l'avion par rapport à la piste. Le récepteur à bord de l'avion reçoit donc un signal VHF à la fréquence de 75 MHz modulé à 95% en amplitude. Les fréquences de modulation et les manipulations MORSE qui les accompagnent sont fonction de la position de la balise émettrice par rapport à l'entrée de piste.

Ainsi, la balise OUTER MARKER émet un signal à 400 Hz manipulé par une succession de traits, la balise MIDDLE MARKER émet un signal à 1300 Hz manipulé par une succession de points et de traits alternés, et la balise INNER MARKER émet un signal de 3000 Hz manipulé par une succession de points, sachant qu'un trait a une durée de 300 ms, un point une durée de 100 ms et un espace, une durée de 100 ms.

Pour synthétiser un tel signal, il suffit de l'échantillonner pour programmer le générateur arbitraire 14, et de l'appliquer à l'entrée du générateur HF 11.

Deux modes de fonctionnement peuvent être envisagés : un mode récurrent (signal périodique permanent) ou un mode à durée définie (signal périodique dont la durée d'émission est limitée).

Toutefois le principe de simulation est indépendant du mode de fonctionnement puisque la sélection de ce dernier dépend uniquement des paramètres de programmation du générateur arbitraire 14. En effet, le premier mode correspond à une programmation du signal à générer en mode récurrent, tandis que le second utilise la fonction de comptage du générateur, ce qui permet de définir la durée d'émission du signal (période du signal x nombre de périodes).

Pour synthétiser le signal émis par la balise OUTER MARKER, il faut utiliser une fréquence d'échantillonnage par exemple égale à 10 fois la fréquence correspondant du signal basse fréquence, soit 4 kHz, et mémoriser 1600 échantillons correspondant à la période du signal MORSE (durée d'un trait (300 ms) et d'un espace (100 ms)) multipliée par la fréquence d'échantillonnage).

Dans le cas du signal émis par la balise MIDDLE MARKER, il faut utiliser une fréquence d'échantillonnage de 13 kHz avec un nombre d'échantillons de 7800 correspondant à une période de signal MORSE de 600 ms (durée d'un point, d'un espace, d'un trait et d'un espace).

De la même manière, pour la balise INNER MARKER, la fréquence d'échantillonnage est de 30 kHz, et le nombre d'échantillons de 6000.

L'amplitude de chaque échantillon est calculée par la relation :

$$0,95 \sin(\omega t),$$

w étant la pulsation correspondant aux fréquences 400, 1300 ou 3000 Hz, selon le cas.

SIGNAUX DME

Le système DME permet à un avion de déterminer sa distance par rapport à une balise au sol. Il repose sur la mesure du temps de réponse des signaux émis par l'avion et utilise la bande allant de 962 à 1213 MHz.

Pour cela, l'avion émet des paires d'impulsions à une fréquence comprise dans la bande allant de 1025 à 1150 MHz, ces impulsions étant reçues par la balise au sol, puis retransmises avec une différence au niveau de la fréquence d'émission de 63 MHz.

A bord de l'avion, un récepteur mesure le temps de réponse séparant les impulsions d'émission des impulsions de réponse, l'information de distance étant déduite du temps de réponse de la balise au sol.

Il s'agit donc de synthétiser des paires d'impulsions qui sont émises qu'après réception d'un signal avec un retard constant de 50 µs auquel est ajouté le temps de simulation de la propagation du signal :

$$\text{Retard} = 50~\mu s + 2d/c$$

c étant la vitesse de la lumière, et d la distance de l'avion à la balise.

Par ailleurs, au signal contenant les impulsions est associé un signal d'identification de la balise à 1020 Hz.

Les impulsions sont synthétisées par le générateur arbitraire 15. A cet effet, il convient, pour définir la forme d'onde préchargée en mémoire, d'utiliser une fréquence d'échantillonnage, par exemple de 2 MHz, compatible avec les caractéristiques des impulsions, à savoir le temps de montée (2 à 3 µs), la durée d'une impulsion (3 à 4 µs), et la durée entre deux impulsions (12 µs) d'une même paire.

Le nombre d'échantillons à mémoriser se déduit de la durée totale d'une paire d'impulsions auquel il faut ajouter le retard (50 µs + 2d/c), divisée par la fréquence d'échantillonnage, soit pour une distance désirée de 100 km :

$$737,5~\mu s~/~0,5~\mu s = 1475~\text{échantillons}$$

Le signal délivré par le générateur 15 est appliqué à l'entrée du générateur HF 11 grâce aux commutateurs C8 et C10 de manière à moduler en amplitude le signal HF à 100%. Le signal en sortie du générateur HF 11 est envoyé grâce au commutateur C11, au circulateur 38, celui-ci transmettant le signal issu du générateur HF 11 à la fois au connecteur 2 et au commutateur C12. Le commutateur C12 applique le signal reçu en entrée du détecteur 36. Le signal en sortie du détecteur 36 est appliqué à l'entrée de déclenchement du générateur arbitraire 15 par l'intermédiaire du diviseur de puissance 37, du détecteur de seuil 39, et du commutateur C9, de manière à déclencher sur le générateur 15, l'émission du signal mémorisé correspondant aux impulsions de réponse.

Par ailleurs, le diviseur de puissance 37 applique le signal issu du détecteur 36 à une entrée du numériseur 21 par l'intermédiaire du commutateur C14, afin de permettre l'observation (mesure du temps de montée et de la durée) des impulsions reçues.

On pourra avantageusement utiliser un filtre analogique passe-bas (non représenté sur la figure) de fréquence de coupure de 500 kHz pour lisser la forme d'onde du signal en sortie du générateur 15.

Si l'on souhaite également introduire le signal d'identification à 1020 Hz, il suffit de programmer en conséquence le générateur 14. Le signal issu du générateur 14 est additionné au signal engendré par le générateur 15 grâce à l'additionneur 34.

il est à noter que tout autre forme d'onde de signal d'identification peut être imaginée à condition de respecter au minimum la relation de Shannon pour la fréquence d'échantillonnage et de ne pas dépasser la capacité de la mémoire du générateur arbitraire mis en oeuvre.

En mode dynamique, le but est de simuler le signal reçu par un avion en approche d'une balise. Il s'agit donc d'animer le signal BF porteur de l'information. L'équipement de bord de l'avion reçoit, en fonction de sa distance par rapport à la balise au sol, une paire d'impulsions plus ou moins retardée. Le retard entre les signaux d'émission et de réception lui permet de déduire sa distance par rapport à la balise.

On va donc, comme en mode statique, utiliser le générateur arbitraire 14 pour générer le signal d'identification de la balise - il peut s'agir notamment d'un signal sinusoïdal de fréquence 1020 Hz, le générateur arbitraire 15 étant utilisé pour générer la paire d'impulsions de réponse. En outre, le générateur 13 est mis en oeuvre pour générer un signal utilisé pour moduler en phase le signal issu du générateur 15. Ce signal varie de -1 à +1 Volt pour faire varier la phase du signal engendré par le générateur 15 de 0 à 180°, simulant ainsi l'approche ou l'éloignement de l'avion par rapport à la balise.

Signaux TACAN

Le TACAN est un système de navigation capable de donner simultanément le cap magnétique dont le principe s'apparente à celui du VOR (l'azimut étant obtenu à bord à partir d'une mesure de phase), et la distance dont le principe est identique à celui du DME. Les signaux DME, lorsqu'ils sont présents sont utilisés pour porter les signaux TACAN.

La balise au sol émet dans la bande allant de 962 à 1213 MHz un signal de référence primaire émis en phase avec le nord magnétique et 8 signaux de référence secondaires intermédiaires espacés de 40°, permettant d'augmenter la précision en azimut. A un même instant, ces signaux seront reçus de façon identique par tous les avions à portée radioélectrique de la balise, indépendamment de leur position.

A ce signal de référence, se superpose un signal variable en amplitude dépendant de la position de l'avion ce qui lui permet d'en déduire sa direction par rapport à la balise (donc par rapport au nord magnétique). A un même instant, ces signaux seront reçus avec une amplitude différente suivant la position de l'avion par rapport à la balise.

A bord de l'avion, un récepteur compare le signal variable aux signaux de référence, ce qui revient à déterminer l'angle que fait la direction avion - balise par rapport au Nord magnétique.

Deux types de codage sont utilisés (un pour les canaux X et un pour les canaux Y). Ces types de codage se différentient par leur bande de fréquence et par leur mode de transmission (sol/air ou air/air).

Toutefois, les principes mis en oeuvre sont indépendants du type de codage et peuvent s'appliquer aussi bien aux autres modes, si bien qu'en simulation, seuls diffèrent les paramètres de programmation des instruments mis en oeuvre.

Le dispositif de simulation doit permettre la génération du signal composite BF, porteur de l'information d'azimut et de distance, utilisé pour moduler un signal HF.

L'avion reçoit simultanément trois types d'informations :

- une information de référence composée du signal de référence primaire et des 8 signaux de référence secondaires, le signal de référence primaire étant composé d'un train d'impulsions comportant 12 paires d'impulsions espacées de 12 µs (pour le canal X), chaque signal de référence secondaire étant constitué d'un train d'impulsions de 6 paires d'impulsions espacées de 24 µs (pour le canal X),

- une information d'azimut de fréquence identique au signal de référence, c'est-à-dire 15 Hz pour la référence primaire et 135 Hz pour la référence secondaire, les espaces entre les trains d'impulsions de référence étant occupés par des impulsions dites de remplissage.

- une information de distance qui s'intercale entre deux trains d'impulsions de référence en lieu et place des impulsions de remplissage.

Le signal de référence primaire, de fréquence égale à la fréquence de rotation de l'antenne (15 Hz), est émis à chaque fois que le lobe d'émission de l'antenne est orienté dans la direction du nord magnétique. Les signaux de référence secondaires sont émis à intervalles réguliers entre deux signaux de référence primaire. Cette technique permet de décomposer le signal de référence en 9 segments équidistants correspondant à une fréquence d'occurrence des signaux de référence (trains d'impulsions) égale à 9 x 15 Hz, soit 135 Hz. Ces signaux de référence sont reçus par l'équipement de bord de l'avion de manière identique et indépendamment de la position de celui-ci par rapport à la balise.

Vu de l'équipement de bord, le signal d'azimut atteint une amplitude maximum lorsque le lobe de l'antenne est orienté dans la direction de l'avion. Ceci revient, d'un point de vue électrique à une modulation d'amplitude de 15 Hz auquel est superposé une autre modulation d'amplitude à 135 Hz. C'est le déphasage entre les signaux de référence et les signaux de modulation à 15 et 135 Hz qui donne l'azimut.

En ce qui concerne l'information de distance, le principe est identique à celui du DME, c'est-à-dire que la distance est déduite du temps aller-retour de l'onde émise par l'avion auquel il y a lieu d'ajouter 50 µs de temps de propagation intrinsèque à l'intérieur de la balise au sol. Puisqu'il s'agit de signaux émis par l'équipement de bord, qui sont asynchrones par rapport aux signaux de référence, la priorité est donnée à ces derniers afin que l'équipement puisse recevoir de manière continue l'information d'azimut. Ainsi, les signaux de distance tombant pendant la durée d'émission d'un train d'impulsion de référence ne seront pas renvoyés par la balise et c'est l'équipement de bord qui se charge d'identifier et de reconnaître le type des impulsions.

Le signal BF composite est constitué par une succession de trains d'impulsions dont l'amplitude évolue au rythme des signaux à 15 et 135 Hz pouvant réaliser une double modulation d'amplitude.

Ainsi, l'amplitude des impulsions suit l'équation :

$$AMP(t) = K1 + K2\cos(2\pi 15t) + K3\cos(2\pi 135t)$$

K1 étant un offset, K2 et K3 les amplitudes respectives pour un taux de modulation compris entre 7 et 30% des signaux à 15 Hz et 135 Hz, K1+K3 l'amplitude pour un taux de modulation compris entre 15 et 55%, K1 étant égal à :

$$1-(K2+K3).$$

Pour la synthèse de tels signaux en mode statique, on utilise le générateur d'impulsions 14, avec une fréquence d'échantillonnage de 4 MHz et un nombre d'échantillons correspondant à une période de 15 Hz complète, soit 266 666 échantillons. L'amplitude du signal est donnée par la formule AMP(t+φ) x f(t), f(t) correspondant au train d'impulsions sur une période de 15 Hz.

Le générateur arbitraire 14 doit être programmé pour qu'il délivre en outre sur sa sortie de déclenchement TRIG OUT un signal permettant de délimiter les instants correspondants aux temps morts. Ce signal est exploité par le multiplexeur analogique 35 pour autoriser l'émission des impulsions DME uniquement pendant l'intervalle de temps entre deux trains d'impulsions de référence.

On utilise également le générateur arbitraire 15 avec une programmation identique à celle utilisée pour la génération des signaux DME, soit une fréquence d'échantillonnage de 2 Mhz, et un nombre d'échantillons qui tient compte également de la nécessité de générer une impulsion supplémentaire qui indique au multiplexeur analogique 35 qu'une réponse à une interrogation DME doit être effectuée, ce qui donne un nombre d'échantillons de 1475 pour une distance de 100 km.

Le signal résultant est obtenu par la combinaison des signaux issus des générateurs arbitraires 14 et 15 grâce à l'additionneur 34. Les impulsions de type DME émises en réponse aux impulsions de distance remplacent des impulsions de remplissage, les amplitudes de ces impulsions devant respecter la formule AMP(t) indiquée ci-avant. Pour ce faire, le détecteur d'enveloppe 33 filtre les impulsions du signal généré par le générateur 14 de manière à ne restituer que le signal de l'enveloppe des amplitudes des impulsions. Ce signal est appliqué sur l'entrée de modulation d'amplitude du générateur arbitraire 15 de manière à ce que l'amplitude des impulsions DME soit cohérente, à un instant donné, avec l'enveloppe du signal à 15 et 135 Hz. Le multiplexeur analogique 35 permet également le passage de ces impulsions durant les temps morts entre deux trains d'impulsions de référence.

Il est à noter que le multiplexeur analogique 35 et l'additionneur 34 doivent assurer une fonction particulière pour substituer à une paire d'impulsions de remplissage une paire d'impulsions de réponse DME. Pour cela, la paire d'impulsions de réponse issue du générateur 15 doit être précédée d'une impulsion de commande qui indique à la logique de commande 51 qu'elle doit remplacer la paire d'impulsions de remplissage par la paire d'impulsions de réponse DME provenant du générateur arbitraire 15, par l'intermédiaire du commutateur C8.

D'une manière générale, la logique de commande 51 est programmée de manière à détecter l'intervalle de temps enveloppe des paires d'impulsions de remplissage et des impulsions DME issues du générateur 15, grâce aux détecteurs à hystérésis 52,53, et autoriser l'émission des impulsions DME et des impulsions TACAN grâce aux adaptateurs de signaux 54,55. L'additionneur 34 a pour rôle de combiner les signaux de sortie des générateurs 14 et 15 au rythme des signaux de commande provenant de la logique de commande 51 et appliqués à l'entrée de commande des adaptateurs de signaux 54,55.

Si l'on utilise un retard de 50 µs, ce qui correspond à une distance DME nulle, le signal en sortie TRIG OUT du générateur 14 délimite l'instant où les impulsions DME peuvent être émises. Ce signal peut être programmé pour être activé par exemple après la dernière paire d'impulsions d'un train de référence, et être désactivé sur le front descendant de la dernière impulsion de remplissage.

L'arrivée de l'impulsion de commande provoque l'invalidation de l'adaptateur de signal 54, et la validation de l'adaptateur de signal 55, ce qui permet de substituer la paire d'impulsions de remplissage suivant l'impulsion de commande, par la paire d'impulsions DME donnant la distance de l'avion à la balise au sol. L'arrivée du dernier front de la paire d'impulsions DME invalide l'adaptateur de signal 55, tandis que l'arrivée du dernier front de la paire d'impulsions de remplissage substituée valide la sortie de l'adaptateur de signal 54.

Comme pour les signaux DME, le signal en sortie du générateur HF 11 est appliqué grâce au commutateur C11 et au circulateur 38, sur la voie d'émission/réception du connecteur 2. Le signal reçu (interrogation DME) est appliqué via la voie de réception du circulateur 38 à la fois à l'entrée de déclenchement du générateur 15 de manière à déclencher l'émission par celui-ci du signal mémorisé correspondant aux impulsions de réponse, et à l'entrée du numériseur 21, afin de permettre l'observation des impulsions reçues.

En mode dynamique, la solution présentée permet d'animer soit le signal DME, soit le signal d'azimut du système TACAN.

Si l'on souhaite animer le signal DME pour simuler le signal reçu par un avion en approche d'une balise, il s'agit d'animer le signal BF porteur de l'information distance, le signal d'azimut étant généré en mode statique.

Le générateur 15 est alors utilisé pour générer la paire d'impulsions de réponse, le générateur 14, pour générer le signal d'azimut dans les mêmes conditions qu'en mode statique, et le générateur 13 pour générer un signal utilisé pour moduler en phase le signal issu du générateur 15.

La programmation de la fréquence d'échantillonnage et des amplitudes des signaux BF des générateurs arbitraires 14 et 15 est identique à celle utilisée en mode statique. Par ailleurs, la phase du signal issu du générateur 15 est proportionnelle à la tension appliquée sur son entrée de modulation de phase et peut varier de 0 à 180° pour simuler l'approche ou l'éloignement de l'avion par rapport à la balise.

Si l'on souhaite animer le signal d'azimut pour simuler l'approche d'une balise, on supprime le signal de distance, et on fait évoluer les paires d'impulsions porteuses de l'information d'azimut au rythme d'un signal à 15 Hz auquel on superpose un signal à 135 Hz. La phase entre ce signal et les paires d'impulsions de référence permet de déterminer une position en azimut par rapport à la balise.

A cet effet, on utilise le générateur 15 pour générer le signal combinant les signaux à 15 Hz et 135 Hz, le générateur 14 pour générer un signal de référence composé des paires d'impulsions de référence et de remplissage dans les mêmes conditions qu'en mode statique, l'amplitude de sortie étant modulée par le signal délivré par le générateur 15, et le générateur 13 pour générer un signal utilisé pour moduler en phase le signal issu du générateur 15.

Les fréquences d'échantillonnage et les amplitudes des échantillons utilisés par les générateurs arbitraires 13,14,15 sont calculées suivant les mêmes règles qu'en mode statique. Par ailleurs, la phase du signal en sortie du générateur 15 est proportionnelle à la tension appliquée sur son entrée de modulation en phase et peut varier de 0 à 180° pour simuler l'évolution en azimut de l'avion par rapport à la balise.

Que l'on anime le signal de distance DME ou le signal d'azimut, l'interface de radio-navigation 3 assure le rebouclage des générateurs comme précisé ci-avant, et transmet le signal BF résultant sur l'entrée de modulation en amplitude du générateur HF 11 qui fournit, selon les paramètres de programmation, le signal HF modulé en amplitude, ce signal étant appliqué sur la voie d'émission/réception du connecteur 2 par l'intermédiaire du circulateur 38. Les signaux reçus sur le connecteur 2 via la voie de réception du circulateur 38 et transmis au détecteur 36, peuvent ainsi être analysés, par exemple, grâce au numériseur 21.

Signaux IFF

Le système IFF permet d'identifier un avion. Il consiste en un processus d'identification qui se base sur le principe question/réponse, et qui est initialisé par un interrogateur au sol qui génère un message d'interrogation émis par modulation d'une porteuse à 1030 MHz, par une antenne directive animée d'un mouvement de rotation.

En réponse l'avion émet un message d'identification sur une porteuse à 1090 MHz.

De plus, grâce aux caractéristiques de rayonnement de l'antenne (bonne directivité en azimut et faisceau large en site), le message d'interrogation permet à l'avion d'identifier son azimut et sa distance par rapport à la balise, l'azimut étant déduit de l'instant de réponse par rapport à la position angulaire de l'antenne, et la distance, comme pour la fonction DME, de la mesure du temps aller et retour nécessaire lors de l'échange des signaux.

On va donc simuler les signaux d'interrogation et acquérir et décoder le message d'identification.

Comme les informations d'azimut et de distance sont du ressort du système au sol, on cherchera uniquement à simuler et acquérir les signaux vus des équipements de bord.

Les signaux d'interrogation sont constitués d'une paire d'impulsions P1 et P3 dont l'espacement dépend du mode d'interrogation, et d'une impulsion P2 située entre P1 et P3.

En fait, le lobe principal de l'antenne s'accompagne de lobes secondaires qui se traduisent, pour l'équipement de bord par des échos multiples qui perturbent le système d'identification. Dans ce contexte, pour améliorer le système, l'impulsion P2 est émise 2 µs après l'impulsion P1 par une antenne omni-directionnelle avec une énergie supérieure à celle des lobes secondaires, mais qui reste inférieure à celle du lobe principal.

Il existe huit modes d'interrogation normalisés qui se différencient par l'espacement (de 3 à 25 µs) entre les impulsions P1 et P3.

En ce qui concerne le signal d'identification, il s'agit d'un signal hyperfréquence modulé par des impulsions espacées de 1,45 µs, le message d'identification étant codé sur 12 bits émis en série, permettant 4096 combinaisons possibles. Il est encadré par deux impulsions d'encadrement F1 et F2 espacées de 20,3 µs et terminé par une impulsion SPI située à 4,35 µs de l'impulsion F2.

Les signaux d'interrogation et de réponse sont normalement séparés par un temps t qui se déduit de la formule suivante :

$$t = 2d/c + 3 \ \mu s \pm 0,5 \ \mu s$$

d étant la distance séparant l'avion de la balise, et
c la vitesse de la lumière.

Comme il s'agit de contrôler l'équipement de bord, on choisira une distance nulle. Par conséquent, le signal d'identification sera émis par l'équipement sous test 3 µs ± 0,5 µs après le front de montée de l'impulsion P3 du signal d'interrogation. A cet effet, on utilise le générateur arbitraire 14 pour générer le signal d'interrogation, dans lequel on a préchargé en mémoire la forme d'onde de chaque impulsion P1, P2, P3, ces impulsions étant transmises via l'interface de radio-navigation 3 sur l'entrée de modulation d'amplitude du générateur HF 11, le signal modulé obtenu en sortie étant appliqué à l'entrée du circulateur 38 qui permet de séparer les signaux d'interrogation des signaux d'identification émis en réponse.

La fréquence d'échantillonnage à utiliser par le générateur 14 doit être compatible avec les formes d'ondes à générer, et se déduit du temps de montée minimum des impulsions d'interrogation, soit 50 ns, ce qui correspond à 20 MHz. Le nombre d'échantillons à mémoriser correspond à une durée égale à l'espacement entre les impulsions P1 et P3, soit 8,1 µs (pour le mode A), à laquelle il faut ajouter le temps de montée de P1 (0,1 µs), le temps de descente de P2 (0,2 µs) et la durée de P3 (0,9 µs), soit au total 9,3 µs.
Le nombre d'échantillons à mémoriser est donc égal à 9,3 µs / 50 ns, soit 186 échantillons.

L'amplitude de chaque échantillons est déduite de la forme d'onde du signal d'interrogation selon les amplitudes désirées pour chaque impulsion.

Le générateur HF doit être programmé pour engendrer une porteuse à 1030 MHz, qui est modulée en amplitude par le signal issu du générateur 14.

L'acquisition du signal de réponse est réalisée par le numériseur 21, le signal de réponse étant séparé du signal d'interrogation par le circulateur 38, et transmis au numériseur 21 après démodulation par le détecteur 36.

Le signal numérisé par le numériseur 21 est alors transmis au calculateur de test 1 qui après traitement décode le message reçu pour analyse.
A cet effet, le numériseur est programmé de manière à déclencher l'acquisition du signal sur sa première entrée. A L'inverse du générateur arbitraire, le numériseur permet l'acquisition et la numérisation d'un signal au rythme d'une fréquence d'échantillonnage définie par les paramètres de programmation. Cette fréquence doit être calculée pour permettre au minimum l'acquisition d'un échantillon à chaque bit constituant le message de réponse, soit au minimum 1/1,45 µs = 689,655 kHz, ce qui correspond à la fréquence d'émission du message.
Dans ces conditions, il suffit de mémoriser 17 échantillons. La capacité importante de la mémoire des numériseurs actuels est mise à profit pour mémoriser plusieurs messages de réponse consécutifs.

Analyse des signaux

Le dispositif d'interface de radio-navigation 3 permet également d'analyser en détail les signaux provenant d'instruments de radio-navigation sous test. A cet effet, le signal à analyser est appliqué au connecteur 2 sur la voie d'émission/réception du circulateur 38 qui le transfère au commutateur C12. Le commutateur C12 oriente ensuite ce signal en direction du détecteur d'enveloppe 36 qui effectue sa démodulation de manière à récupérer le signal BF de modulation de la porteuse. Le signal démodulé est appliqué en entrée du dispositif de commutation 25 par l'intermédiaire du diviseur de puissance 37. Le dispositif de commutation 25 permet ensuite de diriger le signal démodulé à analyser vers le numériseur 21. Si l'on souhaite analyser le signal complet (non démodulé), il suffit de commander le commutateur C12 de manière à ce que le signal soit appliqué directement au dispositif de commutation 25 qui oriente ensuite le signal vers l'analyseur de spectre 23, le fréquencemètre 22, ou le milliwattmètre 24.

Ainsi, le numériseur 21 permet d'acquérir et de mémoriser un signal dans le but d'opérer des traitements par

EP 0 778 469 B1

le calculateur 1.

L'analyseur de spectre 23 est utilisé pour mesurer des puissances de signaux à forme d'onde continue, des fréquences, et le spectre de puissance dans le domaine des fréquences.

Il permet également d'effectuer sur sa sortie auxiliaire OUT des transpositions de fréquence permettant à l'aide du numériseur 21 de réaliser des mesures dans le domaine temporel. Cette disposition présente l'avantage d'autoriser des mesures sur des signaux HF dont la fréquence est supérieure à la bande passante du numériseur 21.

Le milliwattmètre 24 est utilisé pour mesurer des puissances aussi bien sur des signaux à forme d'onde continue, que des signaux impulsionnels avec possibilité de sélecter l'impulsion à analyser dans une trame.

Le fréquencemètre est utilisé pour mesurer des fréquences de signaux à forme d'onde continue, et de signaux impulsionnels modulés par un signal HF avec possibilité de sélecter une impulsion dans une trame, et pour mesurer des largeurs d'impulsions d'un signal impulsionnel modulé par un signal HF.

La description qui précède montre qu'avec un dispositif de conception relativement simple. Il est possible d'engendrer et d'analyser des signaux complexes, tels que ceux utilisés en radio-navigation.

Bien entendu, la structure de ce dispositif peut être modifiée pour engendrer d'autres types de signaux, sans pour autant s'écarter du concept de l'invention telle qu'elle vient d'être décrite.

**Revendications**

1. Procédé pour le test d'instruments de radio-navigation utilisant un système de test automatique pilotant des appareils de mesure (21 à 24) et de génération (11,13,14,15) de signaux électriques, lesdits instruments utilisant des signaux de radio-navigation formés de signaux basse fréquence de formes complexes qui modulent une porteuse haute fréquence **caractérisé en ce qu'**il comprend :

   - l'utilisation de plusieurs appareils de génération de signaux arbitraires programmables points par points qui sont chacun aptes à engendrer un signal primaire basse fréquence présentant des formes d'onde de signaux utilisés dans le domaine de la radionavigation et qui est destiné à moduler une porteuse correspondante délivrée par un générateur haute fréquence à large bande,

   - la combinaison de signaux primaires délivrés par lesdits appareils pour obtenir des signaux composites basse fréquence correspondants à des signaux de radionavigation différents,

   - pour chacun des signaux de radionavigation, la sélection d'une porteuse haute fréquence et l'émission de cette porteuse haute fréquence modulée par le signal composite basse fréquence de manière à obtenir un signal modulé composite,

   - l'application du signal modulé composite à l'instrument à tester,

   - l'analyse des signaux délivrés par l'équipement à tester par des appareils de mesure et d'analyse,

   lesdits générateurs arbitraires et le générateur haute fréquence étant pilotés par un calculateur associé à des moyens de commutation de manière à obtenir sélectivement les susdits signaux composites, à sélectionner la porteuse appropriée à ces signaux composites de manière à obtenir sélectivement lesdits signaux modulés composites, à appliquer ces signaux modulés composites à l'instrument à tester et à effectuer les analyses correspondant à ces signaux modulés composites et à pouvoir exécuter des séquences de test définies au moyen d'un langage de programmation de haut niveau.

2. Procédé selon la revendication 1,
   **caractérisé en ce que** les susdits appareils de mesure et d'analyse comprennent un numériseur, et/ou un fréquencemètre, et/ou un milliwattmètre, et/ou un analyseur de spectre.

3. Procédé selon la revendication 1 ou 2,
   **caractérisé en ce qu'**il comporte l'exécution d'une séquence de test définie par une séquence d'instructions de haut niveau, ladite exécution comprenant la traduction de chaque instruction de haut niveau en une série de commandes élémentaires spécifiques des appareils à mettre en oeuvre pour l'exécution de ladite instruction, et l'émission de chaque commande élémentaire à l'appareil concerné.

4. Procédé selon l'une des revendications précédentes,

**caractérisé en ce qu'**il comprend la démodulation d'un signal de radio-navigation en vue de son analyse à l'aide d'un appareil de mesure (21 à 24).

5. Procédé selon l'une des revendications précédentes,
**caractérisé en ce qu'**il comprend l'utilisation de générateurs de signaux (13 à 15) programmés point par point pour engendrer des signaux primaires basse fréquence de forme d'onde prédéterminée.

6. Procédé selon l'une des revendications précédentes,
**caractérisé en ce qu'**il comprend la génération d'un signal composite basse fréquence en utilisant un signal primaire engendré par un premier générateur de signaux (13 à 15) pour moduler en phase ou en amplitude un signal primaire engendré par un second générateur de signaux (14,15).

7. Procédé selon l'une des revendications précédentes,
**caractérisé en ce qu'**il comprend la génération d'un signal composite basse fréquence en additionnant deux signaux primaires basse fréquence engendrés respectivement par deux générateurs de signaux (14,15).

8. Procédé selon l'une des revendications précédentes,
**caractérisé en ce que** la génération d'un signal composite basse fréquence comprend la synchronisation d'un générateur (15) de signaux basse fréquence à l'aide du signal composite basse fréquence obtenu par démodulation du signal de radio-navigation engendré.

9. Dispositif pour la mise en oeuvre du procédé selon l'une des revendications précédentes,
**caractérisé en ce qu'**il est connecté à des appareils de génération et de mesure de signaux (11, 13 à 15, 21 à 24), et **en ce qu'**il comprend des moyens pour engendrer un signal composite basse fréquence en combinant des signaux primaires basse fréquence provenant desdits appareils standards (13 à 15), des moyens pour moduler une porteuse haute fréquence engendrée par l'un (11) desdits appareils de génération et de mesure de signaux, par le signal composite basse fréquence.

10. Dispositif selon la revendication 9,
**caractérisé en ce qu'**il comprend des moyens de commutation (C1 à C11) permettant d'utiliser chacun des appareils de génération (11, 13, 14, 15) séparément.

11. Dispositif selon la revendication 9 ou 10,
**caractérisé en ce qu'**il comprend des moyens de commutation (C1 à C9) permettant de combiner entre eux les signaux issus de générateurs (13 à 15) de signaux basse fréquence.

12. Dispositif selon l'une des revendications 9 à 10,
**caractérisé en ce qu'**il comprend un additionneur (34) permettant d'additionner deux signaux primaires basse fréquence.

13. Dispositif selon l'une des revendications 9 à 12,
**caractérisé en ce qu'**il comprend un démodulateur (36) permettant de séparer le signal composite basse fréquence de la porteuse haute fréquence.

14. Dispositif selon l'une des revendications 9 à 13,
**caractérisé en ce qu'**il est connecté, ainsi que lesdits appareils de mesure et de génération de signaux (11, 13 à 15, 21 à 24), à un calculateur (1) par l'intermédiaire de bus (12,16), ledit calculateur (1) étant conçu pour commander le dispositif (3) et les appareils (11, 13 à 15, 21 à 24).

15. Dispositif selon l'une des revendications 9 à 13,
**caractérisé en ce qu'**il est connecté à trois générateurs de signaux programmés point par point (13 à 15) permettant de générer un signal composite basse fréquence et un générateur (11) haute fréquence à large bande de modulation d'amplitude permettant de générer une porteuse qui est modulée par le signal composite basse fréquence.

16. Dispositif selon l'une des revendications 9 à 15,
**caractérisé en ce qu'**il comprend un circulateur (38) permettant de séparer un signal produit par le dispositif (3) et appliqué sur une voie de l'équipement à tester, d'un signal de réponse provenant de cette même voie en vue de son analyse par les appareils de mesure (21 à 24).

**Patentansprüche**

1. Verfahren für den Test von Funknavigationsinstrumenten, das ein automatisches Testsystem verwendet, welches Messgeräte (21 bis 24) und Geräte für die Erzeugung von elektrischen Signalen (11, 13, 14, 15) steuert, wobei die genannten Instrumente Funknavigationssignale verwenden, die aus Niederfrequenzsignalen mit komplexer Form bestehen, die einen Hochfrequenzträger modulieren, **dadurch gekennzeichnet, dass** es folgendes beinhaltet:

   - die Verwendung von mehreren Geräten für die Erzeugung von beliebigen Signalen, die Punkt für Punkt programmierbar sind, wobei die Geräte jeweils in der Lage sind ein niederfrequentes Primärsignal zu erzeugen, das die Form von Signalwellen besitzt, wie sie im Bereich der Funknavigation verwendet werden und das dazu bestimmt ist, um einen entsprechenden Träger zu modulieren, der von einem Breitband-Hochfrequenzgenerator abgegeben wird,

   - die Kombination von Primärsignalen, die von den genannten Geräten abgegeben werden, um niederfrequente Signalgemische zu bekommen, die unterschiedlichen Funknavigationssignalen entsprechen,

   - für jedes der Funknavigationssignale, die Auswahl eines Hochfrequenzträgers und die Absendung dieses Hochfrequenzträgers, der anhand des niederfrequenten Signalgemisches moduliert worden ist, um ein moduliertes Signalgemisch zu bekommen,

   - das Anlegen des modulierten Signalgemisches an das zu testende Instrument,

   - die Analyse der von dem zu testenden Instrument abgegebenen Signale anhand von Mess- und Analysegeräten,

   wobei die genannten beliebigen Generatoren und der Hochfrequenzgenerator von einem Rechner gesteuert werden, dem Umschaltvorrichtungen zugeordnet. sind, um selektiv die oben genannten Signalgemische zu erhalten, um den Träger auszuwählen, der sich für diese Signalgemische eignet, um selektiv die genannten modulierten Signalgemische zu erhalten, um diese modulierten Signalgemische an das zu testende Instrument anzulegen und um die Analysen durchzuführen, die diesen modulierten Signalgemischen entsprechen und um die definierten Testsequenzen anhand einer höheren Programmiersprache ausführen zu können.

2. Verfahren gemäß Patentanspruch 1,
   **dadurch gekennzeichnet, dass** die oben genannten Mess- und Analysegeräte ein Digitalisiergerät und/oder ein Frequenzmessgerät und/oder ein Milliwattmessgerät und/oder einen Spektralanalysator beinhalten.

3. Verfahren gemäß Patentanspruch 1 oder 2,
   **dadurch gekennzeichnet, dass** es die Durchführung einer Testsequenz beinhaltet, definiert anhand einer Sequenz von Anweisungen auf hoher Ebene, wobei die genannte Durchführung die Übersetzung jeder Anweisung auf hoher Ebene in eine Serie von spezifischen elementaren Befehlen der zu verwendenden Geräte für die Durchführung der genannten Anweisung und die Absendung jedes elementaren Befehls an das betreffende Gerät beinhaltet.

4. Verfahren gemäß einem der voranstehenden Patentansprüche,
   **dadurch gekennzeichnet, dass** es die Demodulation eines Funknavigationssignals im Hinblick auf dessen Analyse mithilfe eines Messgerätes (21 bis 24) beinhaltet.

5. Verfahren gemäß einem der voranstehenden Patentansprüche,
   **dadurch gekennzeichnet, dass** es die Verwendung von Punkt für Punkt programmierten Signalgeneratoren (13 bis 15) beinhaltet, um niederfrequente Primärsignale mit einer vorgegebenen Wellenform zu erzeugen.

6. Verfahren gemäß einem der voranstehenden Patentansprüche,
   **dadurch gekennzeichnet, dass** es die Erzeugung eines niederfrequenten Signalgemisches beinhaltet, unter Verwendung eines Primärsignals, das von einem ersten Signalgenerator (13 bis 15) erzeugt worden ist, für die Phasen- oder Amplitudenmodulation eines Primärsignals, das von einem zweiten Signalgenerator (14, 15) erzeugt worden ist.

7. Verfahren gemäß einem der voranstehenden Patentansprüche,
   **dadurch gekennzeichnet, dass** es die Erzeugung eines niederfrequenten Signalgemisches beinhaltet, durch Addition von zwei niederfrequenten Primärsignalen, die von zwei Signalgeneratoren (14, 15) erzeugt worden sind.

8. Verfahren gemäß einem der voranstehenden Patentansprüche,
   **dadurch gekennzeichnet, dass** die Erzeugung eines niederfrequenten Signalgemisches die Synchronisation eines Generators (15) für niederfrequente Signale mithilfe des niederfrequenten Signalgemisches beinhaltet, das durch Demodulation des erzeugten Funknavigationssignals erhalten wird.

9. Vorrichtung für die Durchführung des Verfahrens gemäß einem der voranstehenden Patentansprüche,
   **dadurch gekennzeichnet, dass** sie an Geräte für die Erzeugung und Messung von Signalen (11, 13 bis 15, 21 bis 24) angeschlossen ist und dass sie Mittel für die Erzeugung eines niederfrequenten Signalgemisches durch Kombination der niederfrequenten Primärsignale beinhaltet, die von den genannten Standardgeräten (13 bis 15) stammen, und Mittel für die Modulation eines Hochfrequenzträgers, der von einem (11) der genannten Geräte für die Signalerzeugung und -messung erzeugt werden, anhand des niederfrequenten Signalgemisches.

10. Vorrichtung gemäß Patentanspruch 9,
    **dadurch gekennzeichnet, dass** sie Umschaltmittel (CI bis C11) beinhaltet, mit deren Hilfe sich jeder der Generatoren (11, 13, 14, 15) getrennt verwenden lässt.

11. Vorrichtung gemäß Patentanspruch 9 oder 10,
    **dadurch gekennzeichnet, dass** sie Umschaltmittel (CI bis C9) beinhaltet, mit denen sich die Signale untereinander kombinieren lassen, die von den Generatoren für niederfrequente Signale (13, bis 15) abgegeben werden.

12. Vorrichtung gemäß Patentanspruch 9 oder 10,
    **dadurch gekennzeichnet, dass** sie ein Addierglied (34) beinhaltet, mit dem sich zwei niederfrequente Primärsignale addieren lassen.

13. Vorrichtung gemäß einem der Patentansprüche 9 bis 12,
    **dadurch gekennzeichnet, dass** sie einen Demodulator (36) beinhaltet, mit dem sich das niederfrequente Signalgemisch vom Hochfrequenzträger trennen lässt.

14. Vorrichtung gemäß einem der Patentansprüche 9 bis 13,
    **dadurch gekennzeichnet, dass** sie ebenso wie die genannten Signalmessgeräte und -generatoren (11, 13 bis 15, 21 bis 24) über einen Bus (12, 16) an einen Rechner (1) angeschlossen ist, wobei der genannte Rechner (1) für die Steuerung der Vorrichtung (3) und der Geräte (11, 13 bis 15, 21 bis 24) ausgelegt ist.

15. Vorrichtung gemäß einem der Patentansprüche 9 bis 13,
    **dadurch gekennzeichnet, dass** sie an drei Punkt für Punkt programmierte Signalgeneratoren (13 bis 15) angeschlossen ist, die die Erzeugung eines niederfrequenten Signalgemisches ermöglichen, und an einen Hochfrequenz-Breitbandgenerator mit Amplitudenmodulation (11), mit dem sich ein Träger erzeugen lässt, der anhand des niederfrequenten Signalgemisches moduliert wird.

16. Vorrichtung gemäß einem der Patentansprüche 9 bis 15,
    **dadurch gekennzeichnet, dass** sie einen Zirkulator (38) beinhaltet, mit dem sich ein von der Vorrichtung (3) erzeugtes und an einen Kanal des zu testenden Gerätes angelegtes Signal von einem Antwortsignal trennen lässt, das von demselben Kanal stammt, für dessen Analyse anhand der Messgeräte (21 bis 24).

**Claims**

1. A method for testing radio navigation instruments using an automatic testing system driving equipments for measuring (21 to 24) and for generating (11,13,14,15) electric signals, said instruments using radio navigation signals formed by low frequency signals of complex shape which modulate a high frequency carrier wave **characterised in that** it includes:

- the use of several apparatus for generating arbitrary signals programmable points by points which are each one ready to generate a primary low frequency signal presenting of the wave forms of signals used in the radio navigation field and which is intended to modulate a corresponding carrier wave delivered by a high frequency and wide band generator,
- the combination of primary signals delivered by said instruments to obtain composite low frequency signals corresponding to different radio navigation signals,
- for each radio navigation signal, the select of a high frequency carrier wave and the transmission of this high frequency carrier wave modulated by the composite low frequency signal so as to obtain one composite modulated signal,
- the application of the composite modulated signal with the tested instrument,
- the analysis of the signals delivered by the tested instrument by equipments for measuring and analysis,

said arbitrary generators and the high frequency generator being controlled by calculators associated with switching means so as to obtain said composite signals selectively, with select the appropriate carrier wave one to these composite signals so as to obtain said composite modulated signals selectively, to apply these composite modulated signals to the instrument to test and to carry out analysis corresponding to these composite modulated signals and being able to carry out sequences of evaluation defined by means of a programming high level language.

2. Method according according to claim 1,
   **characterised in that** said equipments for measuring and for analysing comprise a digitizer, and/or a frequency meter, and/or a milliwattmeter, and/or a spectrum analyzer.

3. The method according to claim 1 or 2,
   **characterised in that** comprises the performance of a test sequence defined by a sequence of high-level instructions, said performance comprising the translation of each high-level instruction into a series of elementary commands specific to the equipment to be used to perform said instruction, and the transmission of each elementary command to the relevant item of equipment.

4. The method according to one of the preceding claims,
   **characterised in that** comprises the demodulation of a radio navigation signal with a view to analysis thereof by means of measuring equipment (21 to 24).

5. The method according to one of the preceding claims,
   **characterised in that** comprises the utilisation of generators of signals (13 to 15) programmed point by point to generate primary low-frequency signals of predetermined waveshape.

6. The method according to one of the preceding claims,
   **characterised in that** comprises the generating of a composite low-frequency signal by using a primary signal generated by a first signal generator (13 to 15) to phase and amplitude modulate a primary signal generated by a second signal generator (14, 15).

7. The method according to one of the preceding claims,
   **characterised in that** comprises the generating of a low-frequency signal by adding together two composite low-frequency signals respectively generated by two signal generators (14, 15).

8. The method according to one of the preceding claims,
   **characterised in that** the generating of a composite low-frequency signal comprises the synchronization of a low-frequency signal generator (15) by means of the composite low-frequency signal obtained by demodulation of the radio navigation signal generated.

9. A device for implementing the method according to one of the preceding claims,
   **characterised in that** it is connected to standard signal generating and measuring equipment (11, 13 to 15, 21 to 24), and **in that** it comprises a means for generating a composite low-frequency signal by combining primary low-frequency signals coming from said standard equipment (13 to 15), and a means for modulating a high-frequency carrier wave, generated by one (11) of said items of standard equipment, by the composite low-frequency signal.

10. The device according to claim 9,

**characterised in that** it comprises a switching means (C1 to C11) enabling each of the items of generating equipment (11, 13, 14, 15) to be used separately.

11. The device according to claim 9 or 10,
**characterised in that** it comprises a switching means (C1 to C9) enabling the signals coming from said low frequency signal generators (13 to 15) to be combined with one another.

12. The device according to one of the claims 9 to 10,
**characterised in that** it comprises an adder (34) enabling two primary low-frequency signals to be added to one another.

13. The device according to one of the claims 9 to 12,
**characterised in that** it comprises a demodulator (36) enabling the composite low-frequency signal to be separated from the high-frequency carrier wave.

14. The device according to one of the claims 9 to 13,
**characterised in that** it is connected via busses (12, 16), as is said signal measuring and generating equipment (11, 13 to 15, 21 to 24), to a computer (1) designed to control said device (3) and said equipment (11, 13 to 15, 21 to 24).

15. Device according to one of the claims 9 to 13,
**characterised in that** it is connected to three random generators programmed point by point (13 to 15) enabling a composite low-frequency signal to be generated and a high-frequency generator (11) with a large amplitude modulation band enabling the generation of a carrier wave which is modulated by the composite low-frequency signal.

16. Device according to one of the claims 9 to 15,
**characterised in that** it comprises a circulator (38) enabling a signal, produced by the device (3) and applied to a channel of the equipment to be tested, to be separated from a response signal coming from that same channel, with a view to analysis thereof by said measuring equipment (21 to 24).

Fig.1

Fig.3

Fig.2

Fig.4

Additionneur

54

+1

C4

A

57

B

55

+1

A+B

58

56

34

Val DME

Val TACAN

Multiplexeur analogique

52

f

Logique de commande

35

f

53

C5

51

C8